Europäisches Patentamt

European Patent Office

Office européen des brevets

(19)

(11) Numéro de publication : **0 030 486**
**B1**

(12) FASCICULE DE BREVET EUROPÉEN

(45) Date de publication du fascicule du brevet :
28.12.83

(51) Int. Cl.³ : **H 01 L 25/10, H 01 L 23/40**

(21) Numéro de dépôt : **80401606.1**

(22) Date de dépôt : **12.11.80**

(54) **Ensemble redresseur de courant.**

(30) Priorité : **28.11.79 FR 7929221**

(43) Date de publication de la demande :
**17.06.81 Bulletin 81/24**

(45) Mention de la délivrance du brevet :
**28.12.83 Bulletin 83/52**

(84) Etats contractants désignés :
**DE GB IT**

(56) Documents cités :
**FR-A- 2 072 775**
**FR-A- 2 416 552**
**US-A- 3 697 814**

(73) Titulaire : **DUCELLIER & Cie**
**Echat 950**
**F-94024 Créteil Cedex (FR)**

(72) Inventeur : **Walti, Bernard**
**20 Ave du General de Gaulle**
**F-95250 Beauchamps (FR)**

(74) Mandataire : **Habert, Roger et al**
**DUCELLIER & Cie 2, rue Boulle Echat 950**
**F-94024 Creteil Cedex (FR)**

Jouve, 18, rue St-Denis, 75001 Paris, France

Ensemble redresseur de courant

L'invention concerne un ensemble redresseur de courant destiné à coopérer avec un alternateur notamment de véhicule automobile et constitué essentiellement de deux radiateurs thermiques sur lesquels sont montés en pont, deux groupes d'éléments redresseurs en contact thermique et électrique avec lesdits radiateurs soit par leur anode, soit par leur cathode, les deux radiateurs étant de pôle différent et assemblés par des moyens mécaniques pour constituer un ensemble après interposition d'une entretoise isolante enrobant, en les isolant entre elles, des barrettes conductrices assurant chacune la liaison électrique entre l'anode d'un élément redresseur du premier groupe d'éléments redresseurs et la cathode d'un élément redresseur du deuxième groupe, chaque couple de redresseurs ainsi formé est relié à l'anode d'un élément redresseur d'un troisième groupe d'éléments redresseurs dont les cathodes sont reliées entre elles pour alimenter en polarité positive l'enroulement d'excitation de l'alternateur d'une part et qui, d'autre part, peut alimenter un témoin de charge, ledit troisième groupe d'éléments redresseurs étant maintenu sur un support, l'entretoise isolante comportant des moyens de fixation, par encliquetage élastique, du support obtenus de matière avec l'entretoise isolante. Dans ces ensembles redresseurs de courant, connus notamment par le brevet FR.A 2 416 552, l'entretoise isolante est surmoulée sur les barrettes de liaison électrique de chaque pont d'éléments redresseurs de manière à former avantageusement un ensemble compact.

Mais il est nécessaire de prévoir, par l'intermédiaire de canons isolants, un isolement électrique des moyens mécaniques d'assemblage des deux radiateurs, moyens constitués par des rivets métalliques, ce qui accroît le nombre d'éléments constitutifs de tels ensembles redresseurs et en conséquence leur prix de revient.

La présente invention a pour but de remédier à ces inconvénients et concerne à cet effet un ensemble redresseur de courant du type précité caractérisé en ce que l'entretoise isolante comporte, à la fois et obtenus de matière, les moyens mécaniques d'assemblage des deux radiateurs et les moyens de fixation, par encliquetage élastique, du support du troisième groupe d'éléments redresseurs.

La description qui va suivre en regard des figures annexées fera mieux comprendre comment l'invention peut être réalisée.

La figure 1 représente une vue en plan d'un ensemble redresseur conforme à l'invention.

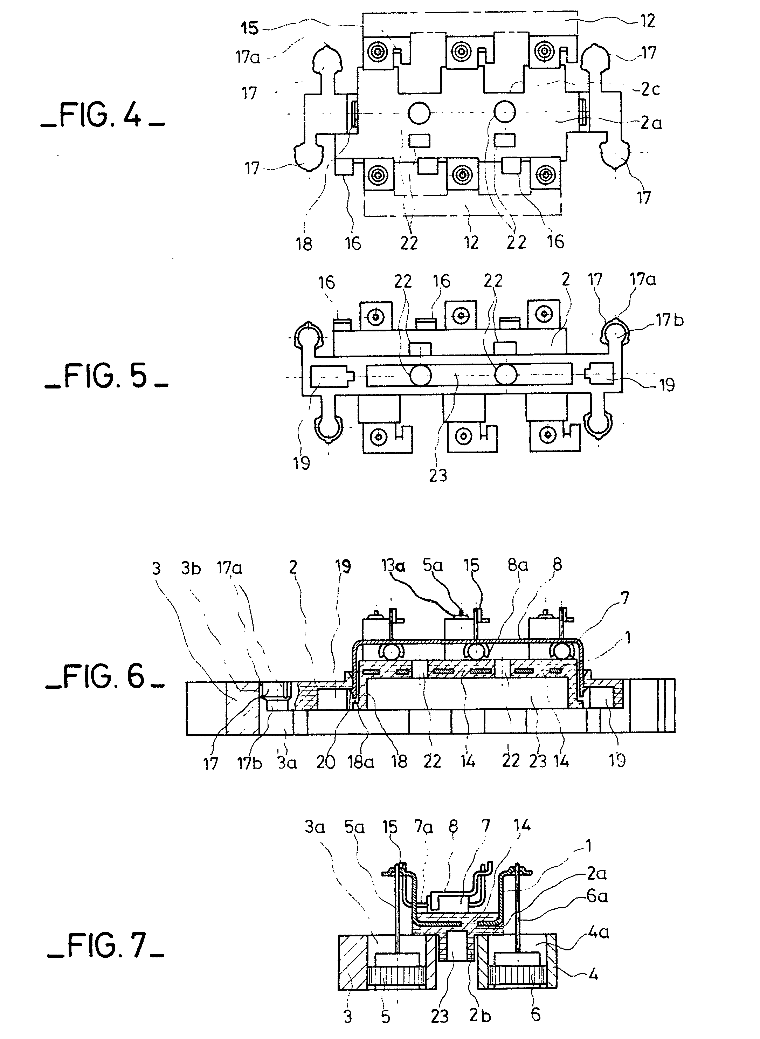

Les figures 2 à 5 représentent les différentes étapes de la réalisation de l'entretoise isolante selon l'invention.

La figure 6 représente ledit ensemble redresseur selon la coupe VI-VI de la figure 1.

La figure 7 représente ledit ensemble redresseur selon la coupe VII-VII de la figure 1.

Cet ensemble redresseur est constitué de façon connue de deux radiateurs 3 et 4 qui comportent chacun trois logements 3a et 4a, dont les axes sont perpendiculaires aux faces planes des radiateurs dans lesquels sont respectivement positionnées trois diodes 5 et trois diodes 6 ; d'une entretoise 2 en matière isolante moulée sur les barrettes conductrices 1, lesquelles relient chacune une diode 5 à une diode 6 ; d'un porte-diodes 8 qui maintient le troisième groupe de diodes 7 ; des moyens de liaison mécanique 10 entre les deux radiateurs 3 et 4 ; des moyens de fixation du porte-diodes 8 ; des moyens 11 de fixation de l'ensemble redresseur sur l'alternateur.

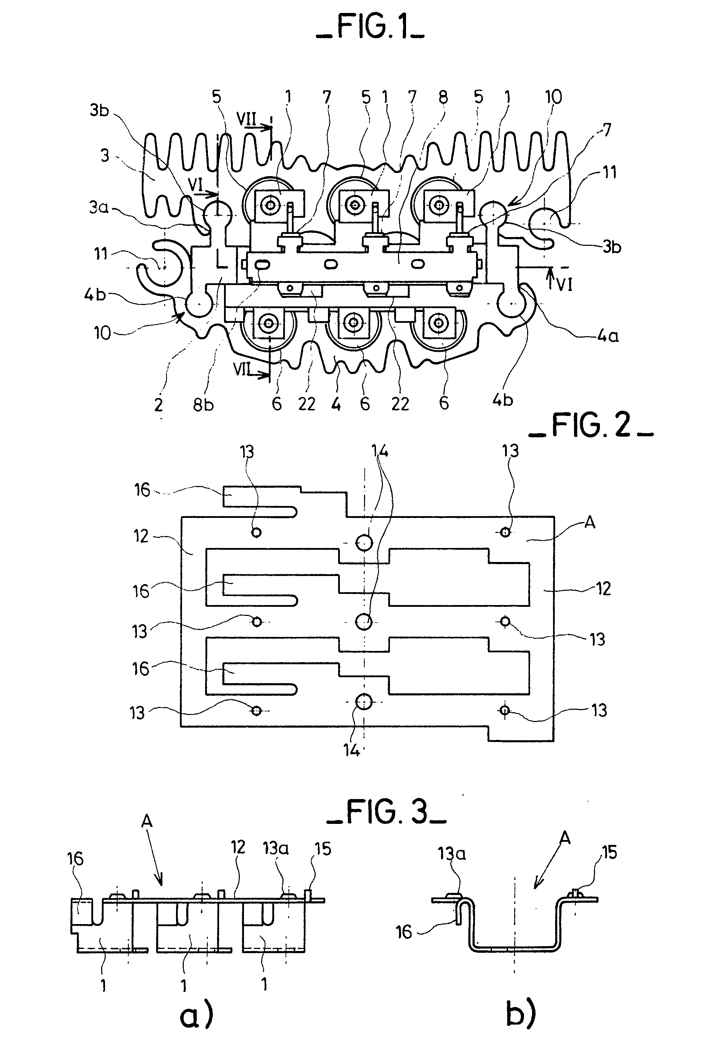

Il est connu, pour la fabrication des barrettes conductrices 1 un procédé dans lequel une feuille métallique conductrice électriquement est découpée suivant la forme désirée des barrettes (fig. 2) et perforée aux endroits appropriés aptes à recevoir les différentes connexions des composants de l'ensemble redresseur. Des liaisons mécaniques 12 sont laissées entre les barrettes 1 lors de ce découpage de façon à réaliser un ensemble A rigide, de manipulation aisée. Ces barrettes 1 sont ensuite en partie enrobées d'une matière isolante surmoulée.

Après ce surmoulage les liaisons mécaniques 12 sont supprimées afin d'assurer l'isolation desdites barrettes 1 les unes par rapport aux autres. L'entretoise isolante 2 ainsi obtenue est ensuite placée entre les deux radiateurs qui sont ainsi isolés l'un par rapport à l'autre.

Conformément à l'invention l'obtention de l'entretoise est réalisée à partir de l'ensemble A (fig. 2) dans lequel ont été réalisés des trous 14 à l'endroit où sera surmoulée la matière isolante. Cet ensemble A est ensuite mis en forme suivant la fig. 3.

Chaque barrette 1 a sensiblement la forme d'une cuvette dont le fond comporte un trou 14 et dont chaque rebord comporte un trou 13 centré dans un emboutissage 13a, les pattes 16 sont rabattues vers le fond de la cuvette et des pattes 15 sont découpées et relevées dans la direction opposée à celui du fond de la cuvette (voir fig. 3b).

La matière isolante est ensuite surmoulée autour du fond de la cuvette suivant la forme désirée de l'entretoise 2, en laissant les extrémités des languettes nues de toute matière ainsi que les différentes pattes 15 et 16. Les orifices 14 assurent le maintien des languettes 1 dans la matière isolante.

La section droite de cette entretoise 2 se présente sensiblement sous la forme d'un T.

Sur la partie supérieure 2a de l'entretoise, des échancrures 2c sont réalisées entre les barrettes 1 d'un côté, et des orifices 22 sont réalisés en vis-à-vis sur l'autre côté et dans la partie centrale de façon à assurer le dégagement calorifique de l'ensemble redresseur tout en maintenant fermement les barrettes 1 et les languettes 16.

L'embase 2b de cette entretoise 2 se prolonge sur toute la longueur de l'entretoise 2 et est d'une largeur apte à assurer l'écartement entre les deux radiateurs 3 et 4. Cette embase comporte en outre vers sa face libre des évidements 19 et 23 séparés par des cloisons 18, et à chacune de ses extrémités, dirigés vers chaque radiateur, des doigts 17 de forme cylindrique qui comporte une partie 17b de plus faible diamètre de façon à assurer leur guidage dans des rainures cylindriques 3b réalisées dans les radiateurs 3 et 4, et le reste comportant des rainures en surépaisseur 17a qui assurent le coincement desdits doigts 17 dans les rainures 3b après montage à force desdits doigts dans lesdites rainures.

Dans chaque cloison 18 est réalisée une rainure 18a débouchante dans le dégagement 19 correspondant, de façon à assurer la fixation du troisième porte-diodes 8 en coopération avec un onglet 20 réalisé dans les extrémités rabattues dudit porte-diodes 8, par encliquetage de cet onglet 20 dans le dégagement 19.

Ce porte-diodes 8 comporte aussi des griffes 8a dans lesquelles les diodes 7 sont montées à force, puis éventuellement, les griffes 8a sont resserrées pour mieux maintenir les diodes 7.

La matière isolante étant surmoulée suivant la forme désirée de l'entretoise 2, il est alors possible de découper les liaisons mécaniques 12 de façon à assurer l'isolation des barrettes 1 entr'elles.

L'assemblage d'un tel ensemble redresseur s'effectue alors de la façon suivante :

Les diodes 5 et 6 sont disposées dans leur radiateur respectif 3 ou 4, l'ensemble entretoise 2 et barrettes 1 est emmanché dans les rainures 3b et 4b des radiateurs, les connexions 5a et 6a des diodes 5 et 6 traversent alors les orifices 13 des barrettes 1, le porte-diodes 8 est encliqueté sur l'entretoise 2 et les connexions 7a des diodes 7 viennent en contact avec les languettes 15. Les différentes soudures des connexions de diodes peuvent alors être effectuées et notamment toutes en même temps au trempé ou à la vague, les soudures se trouvant situées dans un même plan.

Il est alors obtenu un ensemble redresseur monobloc de stockage et manipulation très aisés.

Lors du montage d'un tel ensemble redresseur sur l'alternateur, il ne reste plus qu'à assurer la liaison entre chaque patte 16 solidaire de chaque barrette 1 et un des bobinages du stator ; et celle entre le porte-diodes 8 et le bobinage d'excitation en un endroit quelconque dudit porte-diodes 8 qui comporte des orifices 8b dans lesquels peut être effectuée cette liaison.

Certaines modifications pourront être apportées à une telle réalisation sans sortir pour cela du cadre de l'invention.

## Revendications

1. Ensemble redresseur de courant destiné à coopérer avec un alternateur notamment de véhicule automobile et constitué essentiellement de deux radiateurs thermiques (3 et 4) sur lesquels sont montés en pont, deux groupes d'éléments redresseurs (5 et 6) en contact thermique et électrique avec lesdits radiateurs, soit par leur anode, soit par leur cathode, les deux radiateurs étant de pôle différent, et assemblés par des moyens mécaniques (17) pour constituer un ensemble après interposition d'une entretoise isolante (2) enrobant, en les isolant entre elles, des barrettes conductrices (1) assurant chacune la liaison électrique entre l'anode d'un élément redresseur du premier groupe d'éléments redresseurs (5) et la cathode d'un élément redresseur du deuxième groupe (6) chaque couple de redresseurs ainsi formé est relié à l'anode d'un élément redresseur d'un troisième groupe d'éléments redresseurs (7) dont les cathodes sont reliées entre elles pour alimenter en polarité positive l'enroulement d'excitation de l'alternateur d'une part et qui, d'autre part, peut alimenter un témoin de charge, ledit troisième groupe d'éléments redresseurs (7) étant maintenu sur un support (8), l'entretoise isolante (2) comportant des moyens de fixation (18, 19), par encliquetage élastique, du support (8) obtenus de matière avec l'entretoise isolante (2), ensemble redresseur caractérisé en ce que l'entretoise isolante (2) comporte à la fois et obtenus de matière, les moyens mécaniques (17) d'assemblage des deux radiateurs et les moyens de fixation (18, 19) par encliquetage élastique, du support (8) du troisième groupe d'éléments redresseurs (7).

2. Entretoise isolante selon la revendication 1, caractérisée en ce que les moyens de fixation (18, 19) par encliquetage élastique, du support (8) du troisième groupe d'éléments redresseurs (7) sont constitués par des rainures (18a) réalisées dans les cloisons (18) de l'entretoise isolante (2) et débouchantes dans les dégagements (19), rainures dans lesquelles des pattes rabattues du support (8) du troisième groupe d'éléments redresseurs (7) s'engagent et s'encliquetent à l'aide d'un ergot (20) réalisé sur lesdites pattes rabattues du support (8) en positionnant lesdits éléments redresseurs (7) de façon telle que les soudures de leurs connexions soient situées dans le même plan que les soudures des éléments redresseurs des deux premiers groupes (5 et 6).

## Claims

1. A current rectifier arrangement intended to cooperate with an alternator, particularly of a motor vehicle and essentially comprising two heat radiators (3 and 4) on which are mounted in a bridge array two groups of rectifier elements (5 and 6) in thermal and electrical contact with the said radiators, either via their anode or via their cathode, the two radiators being of different polarity, and assembled by mechanical means (17) to form a whole after interpositioning of an insulating spacer (2) covering, under mutual insulation, conductive strips (1) of which each provides the electrical connection between the anode of a rectifier element of the first group of rectifier elements (5) and the cathode of a rectifier element of the second group (6), each pair of rectifiers thus formed being connected to the anode of a rectifier element of a third group of rectifier elements (7) of which the cathodes are interconnected, for feeding with positive polarity the excitation winding of the alternator on the one hand and which, on the other hand, may supply a charge indicator, the said third group of rectifier elements (7) being held on a carrier (8), the insulating spacer (2) comprising means (18, 19) of fastening by elastic engagement of the carrier (8) obtained integrally with the insulating spacer (2), the rectifier arrangement being characterised in that the insulating spacer (2) comprises both integrally formed mechanical means (17) of assembling the two radiators, and the elastic engagement fastening means (18, 19) for the carrier (8) of the third group of rectifier elements (7).

2. An insulating spacer according to claim 1, characterised in that the elastic engagement fastening means (18, 19) of the carrier (8) of the third group of rectifier elements (7) are formed by grooves (18a) produced in the partitions (18) of the insulating spacer (2) and opening into the recesses (19), being grooves into which bent over lugs of the carrier (8) of the third group of rectifier elements (7) are engaged and caught by means of a stud (20) produced on the said bent over lugs of the carrier (8) whilst positioning the said rectifier elements (7) in such a manner that the solderings of their connections are situated in the same plane as the solderings of the rectifier elements of the first two groups (5 and 6).

**Ansprüche**

1. Stromgleichrichter-Einheit für einen Wechselstromgenerator, insbesondere für Kraftfahrzeuge, mit zwei thermischen Radiatoren (3 und 4), auf denen zwei Gruppen von Gleichrichterelementen (5 und 6) in Brücke montiert sind, die mit den Radiatoren entweder über ihre Anode oder über ihre Kathode in thermischem und elektrischem Kontakt stehen, so daß die beiden Radiatoren unterschiedliche Pole darstellen, wobei die genannten Gleichrichterelemente (5 und 6) durch mechanische Mittel (17) unter Zwischenfügung eines sie umgebenden Zwischenteils (2) aus Isolierstoff unter gegenseitiger Isolierung zu einer Einheit zusammengefaßt sind, mit Leiterstäben (1), die jeweils die elektrische Verbindung zwischen der Anode eines Gleichrichterelements der ersten Gruppe von Gleichrichterelementen (5) und der Kathode eines Gleichrichterelements der zweiten Gruppe (6) herstellen, wobei jedes der so gebildeten Gleichrichterpaare mit der Anode eines Gleichrichterelements einer dritten Gruppe von Gleichrichterelementen (7) verbunden ist, deren Kathoden miteinander verbunden sind und einerseits die Erregerwicklung des Wechselstromgenerators mit positiver Polarität versorgen, die andererseits eine Ladekontrolleuchte zu speisen vermag, wobei die dritte Gruppe von Gleichrichterelementen (7) auf einem Halterungsteil (8) gehalten ist und wobei ferner das isolierende Zwischenteil (2) einstückig mit ihm ausgebildete Befestigungsmittel (18, 19) zur elastisch verrastenden Befestigung des Halterungsteils (8) aufweist, dadurch gekennzeichnet, daß das isolierende Zwischenteil (2) gleichzeitig und einstückig mit ihm ausgebildet die mechanischen Mittel (17) zum Zusammenbau der beiden Radiatoren sowie die Befestigungsmittel (18, 19) zur elastisch verrastenden Befestigung des Halterungsteils (8) der dritten Gruppe von Gleichrichterelementen (7) umfaßt.

2. Isolierendes Zwischenteil nach Anspruch 1, dadurch gekennzeichnet, daß die Befestigungsmittel (18, 19) zur elastisch verrastenden Befestigung des Halterungsteils (8) der dritten Gruppe von Gleichrichterelementen (7) aus in den Wandungen (18) des isolierenden Zwischenteils (2) angebrachten in Ausnehmungen (19) mündenden Nuten (18a) bestehen, in welche abgewinkelte Ansätze des Halterungsteils (8) der dritten Gruppe von Gleichrichterelementen (7) eingreifen und sich mittels eines an den abgewinkelten Ansätzen des Halterungsteils (8) angebrachten Vorsprungs verrasten, wobei die genannten Gleichrichterelemente (7) derart positioniert werden, daß die Lötstellen ihrer Verbindungen in derselben Ebene liegen wie die Lötstellen der Gleichrichterelemente der beiden ersten Gruppen (5, 6).

_FIG.1_

_FIG. 2_

_FIG. 3_

a)

b)

_FIG. 4_

_FIG. 5_

_FIG. 6_

_FIG. 7_